# EUROPEAN PATENT APPLICATION

(11) **EP 4 790 687 A1**
(43) Date of publication of application: **12.08.2026**
(21) Application number: 24902054.6
(22) Date of filing: 17.06.2024
(51) Int. Cl.: G09F 9/30, H10K 50/00, H05K 7/20

(54) **DISPLAY MODULE AND PREPARATION METHOD THEREFOR, AND TERMINAL DEVICE**

(30) Priority: 15.12.2023 CN 202311743247
(71) Applicant: Wuhan China Star Optoelectronics Semiconductor Display Technology Co., Ltd., Wuhan, Hubei 430079 (CN)
(72) Inventor: FANG, Ju, Wuhan, Hubei 430079 (CN)
(74) Representative: Zhu, Puxing
(86) International application number: PCT/CN2024/099488
(87) International publication number: WO 2025/123626

(57) **Abstract**

A display module, a preparation method thereof, and terminal device are provided in embodiments of this application. The display module includes a heat sink, a first backplate, a second backplate, and a display panel. A bending section of the display panel, the heat sink, the first backplate, and the second backplate together define an accommodation cavity. Since an edge of the heat sink is recessed inward relative to edges of the first backplate and the second backplate to form an avoidance region, the volume of the accommodation cavity is increased, so that more adhesive can be accommodated, thereby alleviating excessive overflow of the adhesive.

## Description

This application claims the priority of Chinese Patent Application No. 202311743247.8 filed on December 15, 2023, the entire contents of which are incorporated herein by reference.

### TECHNICAL FIELD

Embodiments of the invention relate to display technologies, and specifically to a display module and a preparation method thereof, and terminal device.

### BACKGROUND

The bending of the bending section in a flexible display panel causes the flexible circuit board and part of the wirings to be bent to the back side, and the bending section has a bending radius and forms a hollow chamber around it. When the entire device falls from a high altitude, the huge impact force causes significant deformation of the middle frame, resulting in defects such as bright lines on the display screen. However, when the existing technology uses adhesive to prepare a supporting member, the adhesive is prone to excessive overflow to both sides under extrusion, leading to display abnormalities.

### SUMMARY

Therefore, the existing display module has a technical problem that the adhesive to form the supporting member is prone to overflow.

Embodiments of the invention provide a display module and preparation method thereof, and terminal device. This may alleviate the technical that the adhesive to form the supporting member is prone to overflow in the existing display modules.

Embodiments of the invention provide a display module, including:
a heat sink;
a first backplate disposed on a side of the heat sink in a thickness direction; and
a second backplate disposed on another side of the heat sink in the thickness direction; and
a display panel including a display section, a planar section, and a bending section, where the display section is disposed on a side of the first backplate away from the heat sink, the planar section is disposed on a side of the second backplate away from the heat sink, the bending section is arranged in a bent configuration, and two ends of the bending section are connected to the display section and the planar section, respectively;
where the bending section, the heat sink, the first backplate, and the second backplate together define an accommodation cavity, edges of the first backplate and the second backplate facing the bending section extend beyond an edge of the heat sink, a supporting member is disposed in the accommodation cavity, and an end of the supporting member is at least abutted against the heat sink.

Embodiments of the invention provide a preparation method of a display module, including:
providing a display panel, where the display panel includes a display section, a planar section, and a bending section located in a same plane;
sequentially preparing a first backplate and a heat sink on a side of the display section of the display panel;
preparing a second backplate on a same side of the planar section of the display panel, and a groove is defined at an interval between the first backplate and the second backplate;
filling the groove with an adhesive;
bending the bending section, so that the second backplate is located on a side of the heat sink away from the first backplate, where an accommodation cavity is defined by the bending section, the heat sink, the first backplate, and the second backplate, the supporting member formed by the adhesive is disposed in the accommodation cavity, an end of the supporting member is at least abutted against the heat sink, and edges of the first backplate and the second backplate facing the bending section extend beyond an edge of the heat sink.

Embodiments of the invention provide a terminal device, including the display module described in the above embodiments. The display module includes:
a heat sink;
a first backplate disposed on a side of the heat sink in a thickness direction; and
a second backplate disposed on another side of the heat sink in the thickness direction; and
a display panel including a display section, a planar section, and a bending section, where the display section is disposed on a side of the first backplate away from the heat sink, the planar section is disposed on a side of the second backplate away from the heat sink, the bending section is arranged in a bent configuration, and two ends of the bending section are connected to the display section and the planar section, respectively;
where the bending section, the heat sink, the first backplate, and the second backplate together define an accommodation cavity, edges of the first backplate and the second backplate facing the bending section extend beyond an edge of the heat sink, a supporting member is disposed in the accommodation cavity, and an end of the supporting member is at least abutted against the heat sink.

### BRIEF DESCRIPTION OF THE DRAWINGS

In order to provide clearer explanations of the technical solutions in the embodiments of the invention, it is to be noted that the drawings in the following description are merely some of embodiments of the invention, and that other drawings may be obtained by the skilled person in the art without involving creative labor.
FIG. 1 is a schematic cross-sectional view of a display module according to the invention.
FIG. 2 is a schematic cross-sectional view of a display module after filling adhesive in a groove according to a preparation method provided by the invention.
FIG. 3 is a top cross-sectional view of the schematic cross-sectional view of the display module in FIG. 2. according to a preparation method provided by the invention.
FIG. 4 is a schematic flowchart of a preparation method of a display module according to the invention.
FIG. 5 is a comparison graph of the stress resistance abilities in the invention when using different adhesives to prepare supporting members and when no supporting members are provided.
FIG. 6 is a graph showing a variation of risk of wiring breakage with displacement when a bending section in the invention is circular.
FIG. 7 is a graph showing a variation of risk of wiring breakage with displacement when a bending section in the invention is elliptical.
FIG. 8 is a comparison graph between the stress resistance capabilities with and without supporting member according to the invention.

**List of the reference signs:**

| Reference signs | Part names | | Reference signs | Part names |
|---|---|---|---|---|
| 10 | heat sink | | 20 | first backplate |
| 30 | second backplate | | 40 | display panel |
| 401 | display section | | 402 | planar section |
| 403 | bending section | | 50 | supporting member |
| 60 | hardened layer | | 70 | polarizer |
| 80 | cover plate | | 90 | light-shielding member |
| 100 | protective layer | | 110 | optical adhesive |
| 120 | printed circuit board | | 130 | black coating layer |
| 140 | chip | | 1 | display module |
| 2 | wiring region | | 3 | reserved region |
| 4 | avoidance region | | | |

### DETAILED DESCRIPTION

The embodiments of the invention only illustrate exemplary embodiments of the inventive concept, and the inventive concept may be embodied in many different forms and should not be construed as being limited to the embodiments described herein.

In combination with drawings in embodiments of the invention, technical solutions in the embodiments of the invention will be described clearly and completely. Apparently, the described embodiments are only part of the embodiments of the invention, not all of them. Based on the embodiments in the invention, all other embodiments obtained by those skilled in the art without involving any inventive effort are within the scope of the invention. In addition, it should be understood that the specific embodiments described herein are only for the purpose of explaining and illustrating the invention and are not intended to limit the invention. In the invention, in the absence of a statement to the contrary, orientation terms such as "on" and "under" are usually used to refer to a position on or under the device in its actual use or operating condition, specifically the orientation of the drawings in the accompanying drawings, and orientation terms such as "inside" and "outside" refer to a position relative to the profile of the device.

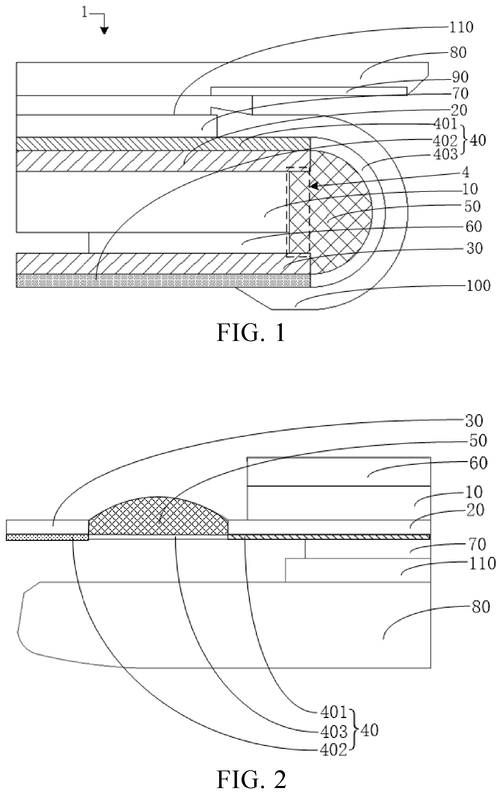

Referring to FIG. 1, FIG.2, and FIG. 3, the display module 1 provided by the invention includes a heat sink 10, a first backplate 20, a second backplate 30 and a display panel 40. The first backplate 20 is disposed on a side of the heat sink 10 along the thickness direction. The second backplate 30 is disposed on another side of the heat sink 10 along the thickness direction. The display panel 40 includes a display section 401, a planar section 402, and a bending section 403. The display section 401 is disposed on a side of the first backplate 20 away from the heat sink 10. The planar section 402 is disposed on a side of the second backplate 30 away from the heat sink 10. The bending section 403 is arranged in a bent configuration. Both ends of the bending section 403 are connected to the display section 401 and the planar section 402, respectively. An accommodation cavity is defined together by the bending section 403, the heat sink 10, the first backplate 20, and the second backplate 30. Edges of the first backplate 10 and the second backplate 20 facing the bending section 30 extend beyond an edge of the heat sink 10. A supporting member 50 is disposed in the accommodation cavity, and an end of the supporting member 50 is abutted against the heat sink 10.

It can be understood that, since the supporting member 50 is provided in the accommodation cavity, after the bending section 403 is compressed by an external force to generate a certain deformation, the supporting member 50 will support the bending section 403, which can improve the pressure resistance load capacity of the accommodation cavity and reduce the amount of deformation generated by the bending section 403 under the external force.

In the embodiments, the supporting member 50 is provided in the accommodation cavity formed by the bending section 403 surrounding to define the cavity, and the supporting member 50 is configured to reduce the amount of deformation of the bending section 403, when preparing the supporting member 50 using adhesive, an edge of the heat sink 10 is recessed inward relative to an edge of the first backplate 20 and an edge of the second backplate 30 so that at least part of the adhesive fills between the first backplate 20 and the second backplate 30, such that an end of the supporting member 50 is at least abutted against the heat sink 10. Since the edge of the heat sink 10 is recessed inward relative to the edges of the first backplate 20 and the second backplate 30 to form an avoidance region 4, the volume of the accommodation cavity increases, which can accommodate more adhesive. In this way, excessive overflow of the adhesive is alleviated, and the technical problem that the adhesive for forming the supporting member easily overflows in the existing display module is solved.

The technical solutions of the invention are described with reference to specific embodiments.

The viscosity of the adhesive, the modulus of the adhesive, the width of the reserved region 3, and the selected material for the supporting member 50 in the invention are described only by means of optimal or preferable implementation manners. Other implementations and ranges also fall within the protection scope of the invention, which will not be repeated herein.

Optionally, in some embodiments of the invention, the bending section includes at least one long edge and at least one short edge which is bent. The extending direction of the long edge is along the first direction. Along the first direction, the bending section includes a wiring region and two reserved regions respectively located on both sides of the wiring region. A plurality of metal wirings are disposed in the wiring region, and the supporting member at least covers the wiring region.

Optionally, in some embodiments of the invention, the display panel further includes a source and a drain, which are arranged at the same layer. At least part of the metal wirings are arranged at the same layer as the source and the drain.

Optionally, in some embodiments of the invention, the display panel further includes a gate driver on array (GOA) circuit, and the GOA circuit includes a lead-out terminal located within the wiring region. Along the first direction, a minimum distance between an edge of the bending section and the lead-out terminal is defined as d1, and a width of the reserved region is defined as d2, satisfying 0.2 mm ≤ d2 < d1.

Optionally, in some embodiments of the invention, the other end of the supporting member is abutted against the bending section.

Optionally, in some embodiments of the invention, the supporting member is contoured to match the accommodation cavity. The outer contour surface of the supporting member is fitted with the inner contour surface of the accommodation cavity.

Optionally, in some embodiments of the invention, a preparation material for the supporting member includes an adhesive.

Optionally, in some embodiments of the invention, the adhesive is at least one of an optical adhesive 110 and a pressure-sensitive adhesive.

Optionally, in some embodiments of the invention, the viscosity of the adhesive ranges from 1300 cP to 4200 cP, and the modulus of the adhesive ranges from 1 GPa to 3 GPa.

Optionally, in some embodiments of the invention, a cross-section shape of the bending contour of the bending section 403 is arc shaped.

Optionally, in some embodiments of the invention, the arc shape is a part of an ellipse or a circle, and the radius of the circle is 0.26 mm, the major axis radius of the ellipse is 0.26 mm, and the minor axis radius of the ellipse is 0.23 mm.

In some embodiments of the invention, the major axis of the semi-ellipse is arranged along the first direction, and the minor axis of the semi-ellipse is perpendicular to the first direction and extends toward the bending vertex of the bending section. The length of the major axis is greater than that of the minor axis.

Optionally, in some embodiments of the invention, the bending section is further provided with one or more stress buffer via holes, and the one or more stress buffer via holes at least penetrate through part of the inorganic film layers within the bending section. The supporting member can also improve the stiffness of the bending section at the one or more stress buffer via holes.

Optionally, in some embodiments of the invention, the supporting member is abutted against a region of the bending section provided with one or more stress buffer via holes.

Optionally, in some embodiments of the invention, the display module further includes a hardened layer, a polarizer, an optical adhesive, a cover plate, a light-shielding member, and a protective layer. The polarizer is disposed on a side of the display section away from the heat sink. The optical adhesive is disposed on a side of the polarizer away from the heat sink. The cover plate is disposed on a side of the optical adhesive away from the heat sink. An edge position of the cover plate is provided with a light-shielding member, and the light-shielding member is configured to prevent light leakage at the edge.

Optionally, in some embodiments of the invention, the protective layer is arranged to cover at least the outer side of the bending section.

Optionally, in some embodiments of the invention, an edge of the hardened layer may be aligned with an edge of the heat sink.

In some embodiments of the invention, portions of the first backplate and the second backplate that extend beyond the edge of the heat sink are symmetrically arranged.

The display section 401 of the invention may be used for display functions, and the planar section 402 may be configured to establish an electrical connection with the printed circuit board 120. The bending section 403 is a bending section.

The display panel 40 of the invention is described by taking the flexible display panel 40 as an example, and the GOA circuit of the invention refers to a gate driver on array (GOA).

Referring to FIG. 1 and FIG. 2, the display module 1 provided in the invention further includes a hardened layer 60, a polarizer 70, an optical adhesive 110, a cover plate 80, a light-shielding member 90, and a protective layer 100. The polarizer 70 is disposed on a side of the display section 401 away from the heat sink 10. The optical adhesive 110 is disposed on a side of the polarizer 70 away from the heat sink 10. The cover plate 80 is disposed on a side of the optical adhesive 110 away from the heat sink 10. An edge position of the cover plate 80 is disposed with a light-shielding member 90, and the light-shielding member 90 is configured to prevent light leakage at the edge.

The protective layer 100 is arranged to at least cover the outer side of the bending section 403 and serves to prevent water vapor from entering the display panel 40 and adjust a neutral layer.

The hardened layer 60 is disposed on a side of the heat sink 10 away from the first backplate 20, and the second backplate 30 is disposed on a side of the hardened layer 60 away from the heat sink 10.

A side of the planar section 402 away from the bending section 403 is further connected to a printed circuit board 120, and the printed circuit board 120 is provided with a chip 140 and a black coating layer 130.

In an embodiment, portions of the first backplate 20 and the second backplate 30 that extend beyond the edge of the heat sink 10 are symmetrically arranged.

The edge of the hardened layer 60 may be aligned with the edge of the heat sink 10.

It can be understood that, when the inward retraction amount of the edge of the heat sink 10 is set to a predetermined value, and the portions of the first backplate 20 and the second backplate 30 extending beyond the edge of the heat sink 10 are symmetrically arranged, the volume of the avoidance region 4 is maximum, which can accommodate more adhesive, further preventing overflow of the adhesive.

In an embodiment, the other end of the supporting member 50 is abutted against the bending section 403.

It can be understood that the two ends of the supporting member 50 are respectively abutted against opposite inner walls of the accommodation cavity, and an end of the supporting member 50 is abutted against at least one of the heat sink 10, the first backplate 20, and the second backplate 30, and the other end of the supporting member 50 is abutted against the bending section 403, so as to provide a better supporting effect on the bending section 403 through the supporting member 50, thereby further reducing deformation of the bending section 403.

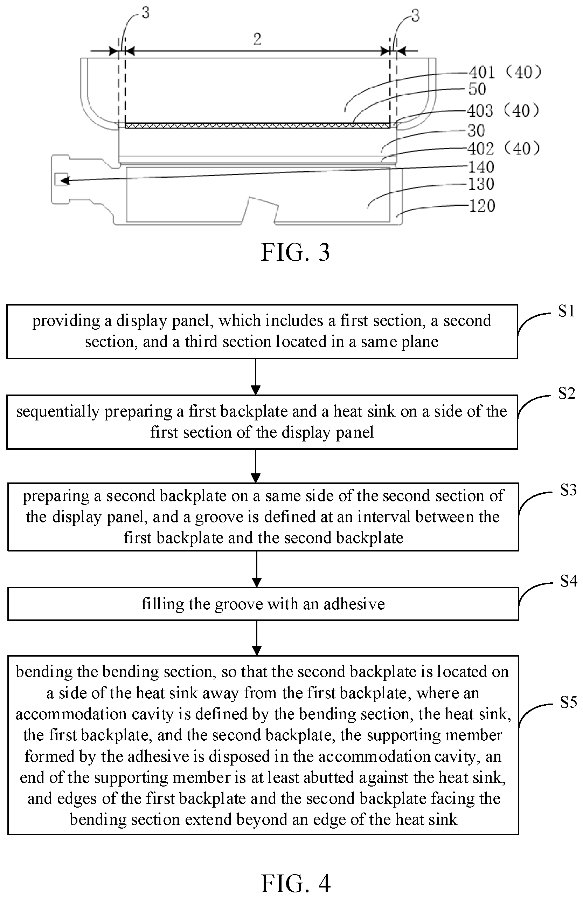

In an embodiment, referring to FIG. 3, the bending section 403 includes a long edge and a short edge which is bent. The extending direction of the long edge is a first direction. Along the first direction, the bending section 403 includes a wiring region 2 and two reserved regions 3 respectively located on two sides of the wiring region 2, the wiring region 2 is provided with a plurality of metal wirings, and the supporting member 50 at least covers the wiring region 2.

At least part of the metal wirings of the wiring region 2 is disposed in the same layer as that of the source, and the drain within the display panel 40.

It can be understood that, when the bending section 403 is deformed due to squeezing, the metal wirings of the wiring region 2 is easily broken under stress. By providing the supporting member 50 at least covering the wiring region 2 provided with the metal wirings, it is possible to better protect the metal wiring and avoid breakage.

In the embodiments, by arranging the supporting member 50 to cover the wiring region 2, the protective effect of the supporting member 50 on the metal wirings in the wiring region 2 is enhanced.

In an embodiment, in the direction of the heat sink 10 towards the accommodation cavity, edges of the first backplate 20 and the second backplate 30 are arranged to extend beyond the edge of the heat sink 10.

An end of the supporting member 50 is abutted against both the first backplate 20 and the second backplate 30.

It can be understood that, since the edges of the first backplate 20 and the second backplate 30 are not aligned with the edge of the heat sink 10, the metal wirings at the contact positions between one edge of the bending section 403 and the edge of the first backplate 20 and between the other edge of the bending section 403 and the edge of the second backplate 30 are more prone to fracture as the bending section 403 deforms. By abutting one end of the supporting member 50 against both the first backplate 20 and the second backplate 30, it is possible to effectively prevent the metal wirings at the edge contact positions from being broken, thereby better protecting the above-mentioned metal wirings at the contact positions.

In the embodiments, in the deformation process of the bending section 403, the stress received by the metal wirings at the contact positions between one edge of the bending section 403 and the edge of the first backplate 20 and between the other edge of the bending section 403 and the edge of the second backplate 30 is larger. By abutting one end of the supporting member 50 against both the first backplate 20 and the second backplate 30, it is possible to better prevent the metal wirings at the above-mentioned contact positions from being broken.

In an embodiment, referring to FIG. 3, the display panel 40 further includes a GOA circuit. The GOA circuit 40 includes a lead-out terminal located in the wiring region 2. Along the first direction, a minimum distance between an edge of the bending section 403 and the lead-out terminal is defined as d1, and a width of the reserved region 3 is defined as d2, satisfying 0.2 mm ≤ d2 < d1.

It can be understood that, by limiting the width of the reserved region 3, and the width of the reserved region 3 being greater than 0.2 mm, when the supporting member 50 is prepared using the adhesive, the reserved region 3 is configured for accommodating the adhesive flowing toward both sides due to extrusion, thereby preventing overflow caused by extrusion of the adhesive.

It can be understood that, since the wiring region 2 is provided with the lead-out terminal of the GOA circuit, there may still exist a certain distance between the lead-out terminal and an edge of the wiring region. Therefore, the set width of the reserved region 3 shall not exceed the minimum distance between the lead-out terminal and the edge of the bending section in the first direction, so as to prevent the arrangement of the reserved region from affecting the layout of the lead-out terminal of the GOA circuit.

In the embodiments, by providing the reserved region 3 and limiting the width d2 of the reserved region 3 to satisfy: 0.2 mm ≤ d2 < d1, overflow of the adhesive forming the supporting member 50 due to extrusion after the bending section 403 is bent during the preparation of the supporting member 50 is avoided.

In an embodiment, the supporting member 50 is contoured to match the accommodation cavity, and the outer contour surface of the supporting member 50 is fitted with the inner contour surface of the accommodation cavity.

It can be understood that the supporting member 50 may be prepared by an adhesive, and during bending of the bending section 403, the adhesive is prone to adopting a profile-matching design with the accommodation cavity, such that there are no gap between the supporting member 50 and the inner walls of the accommodation cavity. Therefore, when the bending section 403 is deformed due to being squeezed, the supporting member 50 can provide a supporting force for the bending section 403. This is equivalent to improving pressure resistance load capacity.

Specifically, in the embodiments, an inner wall of the bending section 403 is abutted against the supporting member 50. When the middle frame presses the bending section 403, the pressure resistance load capacity of the bending section 403 and the supporting member 50 as an integral structure is at least four times that of a structure provided with only the bending section 403.

In the embodiments, since the supporting member 50 adopts a profiling design matching the accommodation cavity, there is no gap between the supporting member 50 and the accommodation cavity, which further optimizes the supporting effect of the supporting member 50 on the bending section 403, enhances the pressure resistance load capacity of the bending section 403 and the supporting member 50 as an integral structure, so that when the bending section 403 is squeezed by the middle frame or the like, the bending section 403 is less likely to be deformed.

In an embodiment, the preparation material of the supporting member 50 includes adhesive.

The adhesive is at least one of an optical adhesive 110 and a pressure-sensitive adhesive.

It can be understood that, from the perspective of process, it is easier to prepare the supporting member 50 using an adhesive. However, the invention includes but is not limited to the adhesive. For example, the supporting member 50 may be provided as a separate component on the side surfaces of the heat sink 10, the first backplate 20, and the second backplate 30 facing the accommodation cavity.

In an embodiment, the viscosity of the adhesive ranges from 1300 cP to 4200 cP, and the modulus of the adhesive ranges from 1 GPa to 3 GPa.

The viscosity of the adhesive may be 1300 cP, 2000 cP, 3000 cP or 4200 cP.

The modulus of the adhesive may be 1 GPa, 2 GPa or 3 GPa.

Optionally, the viscosity of the adhesive ranges from 3000 cP to 4200 cP.

Optionally, the modulus of elasticity of the adhesive may be in a range from 2 GPa to 3 GPa.

It can be understood that the viscosity range of the adhesive may be the viscosity of an adhesive layer which is available in an adhesive coating process.

It can be understood that the greater the viscosity of the adhesive is, the lower the fluidity of the adhesive before curing is, and thus the smaller the influence on metal wirings is. The greater the modulus of the adhesive is, the stronger the pressure resistance load capacity of the supporting member 50 prepared using the adhesive is.

In the embodiments, by limiting the modulus and viscosity of the adhesive for preparing the supporting member 50, on one hand, it reduces the influence of the adhesive in the manufacturing process on the process and wiring stress; on the other hand, it also enhances the pressure resistance load capacity of the supporting member 50.

In an embodiment, the major axis of the semi-ellipse is disposed along the first direction, and the minor axis of the semi-ellipse is perpendicular to the first direction and directed toward the bending vertex of the bending section. The length of the major axis is greater than that of the minor axis.

The bending vertex of the bending section refers to a vertex on the minor axis of the semi-ellipse.

It can be understood that the set direction of the minor axis is the width direction of the border. The effect of narrow border can be realized by reducing a length of the minor axis.

In an embodiment, the cross-section shape of the bending contour of the bending section 403 is arc-shaped, and the arc shape is a part of an ellipse or a circle.

The radius of the circle may be 0.26 mm.

The major axis radius of the ellipse may be 0.26 mm, and the minor axis radius of the ellipse may be 0.23 mm.

It can be understood that the major axis of the ellipse is provided in a second direction, and the minor axis of the ellipse is provided along a width direction of the border. By reducing the width of the minor axis of the ellipse, the width of the border can be reduced. The second direction may be a film thickness direction of the display module 1.

Optionally, since the supporting member 50 is provided, the overall pressure resistance load capacity of the bending section 403 and the supporting member 50 becomes stronger. Therefore, the major axis and minor axis of the ellipse may be arranged to be smaller to achieve a narrower border.

Specifically, the major axis radius of the ellipse may be 0.23 mm, and the minor axis radius of the ellipse may be 0.17 mm.

It can be understood that, when the cross-section shape of the bending contour of the bending section 403 is a part of an ellipse, compared with the case where the cross-section shape of the bending contour of the bending section 403 is a part, the stress of the metal wirings at edges of the first backplate 20 and the second backplate 30 will be larger. Therefore, when the cross-section shape of the bending contour of the bending section 403 is a part of the ellipse, the supporting member 50 may have better effect in preventing the bending section 403 from being deformed under squeezing.

It should be noted that, along the second direction, for the bending section 403, if its major axis radius in an elliptical configuration is equal to its radius in a circular configuration, then the minor axis radius in the elliptical configuration is smaller than the radius of the circle. In other words, when the cross-section shape of the bending contour of the bending section 403 is a part of an ellipse, the border can be made narrower.

It should be noted that, since the above design improves the pressure resistance load capacity of the bending section 403, the safety distance between the bending section 403 and the middle frame can be further reduced to achieve a narrow border design.

In the embodiments, the cross-section shape of the bending contour of the bending section 403 is arc shaped. When the arc shape is a part of an ellipse, the minor axis of the ellipse is disposed along the width direction of the border, which can further reduce the width of the border.

In an embodiment, the cross-section shape of the bending contour of the bending section 403 is a half ellipse or a half circle.

In an embodiment, the bending section 403 is further provided with one or more stress buffer via holes, and the one or more stress buffer via holes at least penetrate through part of the inorganic film layers within the bending section 403. The supporting member 50 can also improve the rigidity of the bending section 403 at the one or more stress buffer via holes.

The supporting member 50 may further be abutted against a region of the bending section 403 provided with one or more stress buffer via holes.

It can be understood that, since the bending performance of the inorganic film layers is poor, to enable the bending section 403 of the display panel 40 to bend better, one or more stress buffer via holes are provided. The one or more stress buffer via holes penetrate through at least part of the inorganic film layers, so that the thickness of the inorganic film layers is reduced, and it is easier for the bending section 403 to bend. In the invention, by providing a supporting member 50 inside the accommodation cavity, the supporting member 50 may be abutted against an region where the bending section 403 has one or more stress buffer via holes, so as to improve the rigidity of the bending section 403 at the one or more stress buffer via holes.

In the embodiments, since the bending section 403 is further provided with one or more stress buffer via holes penetrating through at least part of the inorganic film layers, on one hand, it can better relieve the stress generated by bending of the bending section 403, on the other hand, since the supporting member 50 abuts against the region where the bending section 403 has one or more stress buffer via holes, the rigidity of the bending section 403 at the one or more stress buffer via holes may also be improved.

Referring to FIG. 4, embodiments of the invention provide a preparation method of the display module 1, including the following step.

At step S1, a display panel 40 is provided, where the display panel 40 includes a display section 401, a planar section 402, and a bending section 403 located in a same plane.

At step S2, a first backplate 20 and a heat sink 10 are prepared in sequence on a side of the display section 401 of the display panel 40.

At step S3, a second backplate 30 on the same side of the planar section 402 of the display panel 40 is prepared, and a groove is defined at an interval between the first backplate 20 and the second backplate 30.

At step S4, the groove is filled with an adhesive.

At step S5, the bending section 403 is bent so that the second backplate 30 is located on a side of the heat sink 10 away from the first backplate 20, where an accommodation cavity is defined by the bending section 403, the heat sink 10, the first backplate 20, and the second backplate 30, a supporting member 50 formed by the adhesive is disposed in the accommodation cavity, an end of the supporting member 50 is at least abutted against the heat sink 10, and edges of the first backplate 20 and the second backplate 30 facing the bending section 403 extend beyond an edge of the heat sink 10.

The adhesive is only disposed in the groove, and surfaces of the first backplate 20 and the second backplate 30 away from the display panel 40 are not provided with the adhesive.

The step of filling the groove with the adhesive may be performed after preparing the heat sink 10 and before preparing the hardened layer 60.

The filling may be performed manually.

The adhesive may be applied by a dispensing machine, so that the adhesive is disposed in the groove. The dispensing machine may be in an offline state.

In an embodiment, the step of placing the second backplate 30 on a side of the heat sink 10 away from the first backplate 20 further including: preparing an hardened layer 60 on a side of the heat sink 10 away from the display section, and bending the bending section 403 to place the second backplate 30 on a surface of the hardened layer 60 away from the heat sink 10.

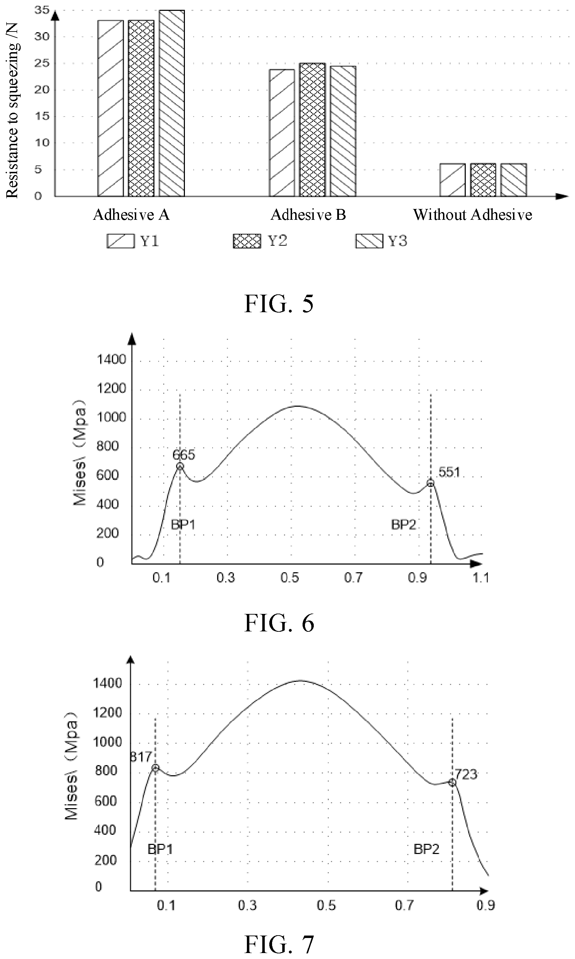

Referring to FIG. 5, for the randomly selected experimental samples Y1, Y2 and Y3, the supporting member 50 are prepared using adhesive A and adhesive B with different modulus respectively, and no supporting member is provided as a Comparative Example, where the modulus of the adhesive A is greater than that of the adhesive B, and the ordinate represents the value of the resistance to squeezing, with the unit being newtons (N). It can be understood that, by preparing the supporting member 50 using the adhesive, the resistance to squeezing of the whole constituted by the bending section 403 and the supporting member 50 can be increased obviously, and the resistance to squeezing of the supporting member 50 obtained using the adhesive with higher modulus is stronger.

It should be noted that FIG. 5 to FIG. 8 are all experimental groups of the case where the supporting member 50 is in the similar design with and fitted with the accommodation cavity.

Comparing FIG. 6 and FIG. 7, where FIG. 6 shows an experiment on the variation of metal wiring risks with displacement for a sample in which the cross-section shape of the bending contour of the bending section 403 is an arc with radius of 0.26 mm; and FIG. 7 shows an experiment on the variation of metal wiring risk with displacement for a sample in which the cross-section shape of the bending contour of the bending section 403 is arc-shaped, specifically, the arc is a semi-ellipse with a major axis radius of 0.26 mm and a minor axis radius of 0.23 mm.

It can be understood that the vertical coordinates in FIG. 6 and FIG. 7 represents a stress value of the metal wiring of the source-drain layer in the wiring region 2. The larger the value is, the higher the risk of wiring breakage is. The horizontal coordinates in FIG. 6 and FIG. 7 refer to displacement. The displacement refers to a length of the metal wiring in the wiring region 2, a dotted line BP1 refers to a stress value of the metal wiring at the position where the first backplate 20 is located. and a dotted line BP2 refers to the stress value of the metal wiring at the position where the second backplate 30 is located.

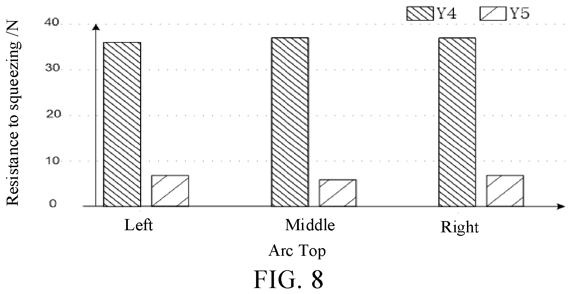

Referring to FIG. 8, which shows a comparison of the resistance to squeezing of metal wirings with and without the supporting member 50 when the cross-section shape of the bending contour of the bending section 403 is a part of an ellipse.

The horizontal coordinate is a position of an arc top, and the arc top refers to the three distinct regions, namely left, middle and right, corresponding to the metal wirings of the wiring region 2 in the first direction. The vertical coordinates represent the resistance to squeezing of different regions with and without the supporting member 50 for the randomly selected experimental samples Y4 and Y5.

In the invention, a supporting member 50 is provided in an accommodation cavity enclosed by the bending section 403 of the display panel 40, the heat sink 10, the first backplate 20, and the second backplate 30. and an end of the supporting member 50 is abutted against the side surface of at least one of the heat sink 10, the first backplate 20, and the second backplate 30, so that when the bending section 403 is deformed under squeezing, the deformation amount of the bending section 403 can be reduced through the supporting member 50, which can prevent the metal wirings from being broken due to excessive deformation amount, and alleviate the bright line problem caused by deformation of the bending section 403 under external force squeezing. Optionally, the invention may include, but is not limited to, filling adhesive into the accommodation cavity to prepare the supporting member 50.

In the invention, the supporting member is provided in the accommodation cavity formed by the bending section surrounding to define the cavity, and the supporting member is configured to reduce the amount of deformation of the bending section, when preparing the supporting member using adhesive, an edge of the heat sink is recessed inward relative to an edge of the first backplate and an edge of the second backplate so that at least part of the adhesive fills between the first backplate and the second backplate, such that an end of the supporting member is at least abutted against the heat sink. Since the edge of the heat sink is recessed inward relative to the edges of the first backplate and the second backplate to form an avoidance region, the volume of the accommodation cavity increases, which can accommodate more adhesive. In this way, excessive overflow of the adhesive is alleviated, and the technical problem that the adhesive for forming the supporting member easily overflows in the existing display module is solved.

The invention further provides a terminal device, the terminal device includes the above display module, which are not repeated herein. The terminal device further includes a front frame and a middle frame. The terminal device includes, but is not limited to, a mobile phone, a computer, or a tablet display device.

The display module provided by the embodiments of the invention includes a heat sink, a first backplate, a second backplate, and a display panel. The first backplate is disposed on a side of the heat sink in the thickness direction, and the second backplate is disposed on another side of the heat sink in the thickness direction. The display panel includes a display section, a planar section, and a bending section. The display section is disposed on a side of the first backplate away from the heat sink, the planar section is disposed on a side of the second backplate away from the heat sink, and the bending section is arranged in a bent configuration. Two ends of the bending section are respectively connected to the display section and the planar section. The bending section, the heat sink, the first backplate, and the second backplate together define an accommodation cavity, edges of the first backplate and the second backplate facing the bending section extend beyond an edge of the heat sink, a supporting member is disposed in the accommodation cavity, and an end of the supporting member is at least abutted against the heat sink. The supporting member is provided in the accommodation cavity formed by the bending section surrounding to define the cavity, and the supporting member is configured to reduce the amount of deformation of the bending section, when preparing the supporting member using adhesive, an edge of the heat sink is recessed inward relative to an edge of the first backplate and an edge of the second backplate so that at least part of the adhesive fills between the first backplate and the second backplate, such that an end of the supporting member is at least abutted against the heat sink. Since the edge of the heat sink is recessed inward relative to the edges of the first backplate and the second backplate to form an avoidance region, the volume of the accommodation cavity increases, which can accommodate more adhesive. In this way, excessive overflow of the adhesive is alleviated, and the technical problem that the adhesive for forming the supporting member easily overflows in the existing display module is solved.

In the foregoing embodiments, the descriptions of each embodiment have their own emphasis, and for parts not described in detail in a certain embodiment, reference may be made to relevant descriptions of other embodiments.

The display module, the display module, and the preparation method provided in the embodiments of the invention are described above in detail. The principles and implementations of the invention are illustrated using specific examples herein. The description of the foregoing embodiments is only used to help understand the method and core ideas of the invention; meanwhile, for those skilled in the art, changes may be made to the specific implementation manners and application ranges according to the ideas of the invention. In conclusion, the content of this specification should not be construed as a limitation to the invention.

## Claims

1. A display module, comprising:
a heat sink;
a first backplate disposed on a side of the heat sink in a thickness direction;
a second backplate disposed on another side of the heat sink in the thickness direction; and
a display panel comprising a display section, a planar section, and a bending section, wherein the display section is disposed on a side of the first backplate away from the heat sink, the planar section is disposed on a side of the second backplate away from the heat sink, the bending section is arranged in a bent configuration, and two ends of the bending section are connected to the display section and the planar section, respectively;
**characterized in that** the bending section, the heat sink, the first backplate, and the second backplate together define an accommodation cavity, edges of the first backplate and the second backplate facing the bending section extend beyond an edge of the heat sink, a supporting member is disposed in the accommodation cavity, and an end of the supporting member is at least abutted against the heat sink.

2. The display module of claim 1, wherein the bending section comprises a long edge and a short edge which is bent, an extending direction of the long edge is a first direction, and along the first direction, the bending section comprises a wiring region and two reserved regions respectively located on both sides of the wiring region, the wiring region is provided with a plurality of metal wirings, and the supporting member at least covers the wiring region.

3. The display module of claim 2, wherein the display panel further comprises a source and a drain arranged in the same layer as each other, at least part of the metal wirings is arranged in the same layer as the source and the drain.

4. The display module of claim 2, wherein the display panel further comprises a gate driver on array (GOA) circuit, and the GOA circuit comprises a lead-out terminal located in the wiring region, along the first direction, a minimum distance between an edge of the bending section and the lead-out terminal is defined as d1, and a width of the reserved region is defined as d2, satisfying 0.2 mm ≤ d2 < d1.

5. The display module of claim 1, wherein another end of the supporting member is abutted against the bending section.

6. The display module of claim 4, wherein the supporting member is contoured to match the accommodation cavity, and an outer contour surface of the supporting member is fitted with an inner contour surface of the accommodation cavity.

7. The display module of claim 1, wherein a preparation material of the supporting member includes an adhesive.

8. The display module of claim 7, wherein the adhesive is at least one of an optical adhesive and a pressure-sensitive adhesive.

9. The display module of claim 7, wherein an adhesive has a viscosity ranging from 1300 centipoise to 4200 centipoise and a modulus ranging from 1 gigapascal to 3 gigapascals.

10. The display module of claim 1, wherein a cross-section shape of a bending contour of the bending section is an arc shape.

11. The display module of claim 10, wherein the arc shape is a part of an ellipse or a part of a circle, a radius of the circle is 0.26 mm, a major axis radius of the ellipse is 0.26 mm, and a minor axis radius of the ellipse is 0.23 mm.

12. The display module of claim 11, wherein a major axis of the semi-ellipse is disposed in the first direction, and a minor axis of the semi-ellipse is perpendicular to the first direction and directed toward a bending vertex of the bending section, wherein a length of the major axis is greater than a length of the minor axis.

13. The display module of claim 1, wherein the bending section is further provided with one or more stress buffer via holes, and the one or more stress buffer via holes at least penetrate through part of inorganic film layers within the bending section.

14. The display module of claim 13, wherein the supporting member is abutted against a region of the bending section provided with the one or more stress buffer via holes.

15. The display module of claim 1, wherein the display module further comprises a hardened layer, a polarizer, an optical adhesive, a cover plate, a light-shielding member, and a protective layer, the polarizer is disposed on a side of the display section away from the heat sink, the optical adhesive is disposed on a side of the polarizer away from the heat sink, the cover plate is disposed on a side of the optical adhesive away from the heat sink, and an edge position of the cover plate is provided with a light-shielding member.

16. The display module of claim 15, wherein the protective layer is arranged at least covering an outer side of the bending section.

17. The display module of claim 15, wherein an edge of the hardened layer is aligned with the edge of the heat sink.

18. The display module of claim 1, wherein portions of the first backplate and the second backplate extending beyond the edge of the heat sink are symmetrically arranged.

19. A display module preparation method, comprising:
providing a display panel, wherein the display panel comprises a display section, a planar section, and a bending section located in a same plane;
sequentially preparing a first backplate and a heat sink on a side of the display section of the display panel;
preparing a second backplate on a same side of the planar section of the display panel, and a groove is defined at an interval between the first backplate and the second backplate;
filling the groove with an adhesive;
bending the bending section, so that the second backplate is located on a side of the heat sink away from the first backplate, wherein an accommodation cavity is defined by the bending section, the heat sink, the first backplate, and the second backplate, the supporting member formed by the adhesive is disposed in the accommodation cavity, an end of the supporting member is at least abutted against the heat sink, and edges of the first backplate and the second backplate facing the bending section extend beyond an edge of the heat sink.

20. A terminal device, comprising the display module as claimed in any one of claims 1 to 18.
